Europäisches Patentamt

European Patent Office

Office européen des brevets

(19)

(11) Numéro de publication: **0 256 581**
**A1**

(12) # DEMANDE DE BREVET EUROPEEN

(21) Numéro de dépôt: **87201398.2**

(22) Date de dépôt: **21.07.87**

(51) Int. Cl.4: **H05K 1/18** , H05K 3/32

(30) Priorité: **06.08.86 FR 8611385**

(43) Date de publication de la demande:
**24.02.88 Bulletin 88/08**

(84) Etats contractants désignés:
**DE FR GB NL**

(71) Demandeur: **RTC-COMPELEC**
**130, Avenue Ledru-Rollin**
**F-75011 Paris(FR)**

(84) **FR**

(71) Demandeur: **N.V. Philips'**
**Gloeilampenfabrieken**
**Groenewoudseweg 1**
**NL-5621 BA Eindhoven(NL)**

(84) **DE GB NL**

(72) Inventeur: **Robert, Jean-Michel Société Civile**
**S.P.I.D.**
**209, rue de l'Université**
**F-76007 Paris(FR)**

(74) Mandataire: **Caron, Jean et al**
**SOCIETE CIVILE S.P.I.D. 209, rue de**
**l'Université**
**F-75007 Paris(FR)**

(54) **Circuit imprimé souple à composants en surface, et procédé pour le fabriquer.**

(57) Pour assurer la fixation d'un composant CMS (1) sur un circuit imprimé souple (5), on découpe dans ce dernier un orifice correspondant à la forme du composant en ménageant des languettes (2) qui sont pliées lors de l'introduction du composant dans l'orifice et maintiennent le composant par la suite.

Application aux circuits souples et particulièrement à ceux utilisés dans les claviers.

FIG.2A

FIG.2C

## "CIRCUIT IMPRIME SOUPLE A COMPOSANTS EN SURFACE, ET PROCEDE POUR LE FABRIQUER"

L'invention concerne un circuit électrique comportant des pistes conductrices imprimées sur un feuille isolante souple et muni d'au moins un composant pour montage en surface, dit "CMS".

Elle concerne également un procédé pour réaliser ce circuit et une application de ce circuit.

Les composants CMS peuvent être connectés soit au moyen d'une colle conductrice, soit au moyen de soudure. Dans les deux cas, des problèmes se posent pour la manutention des circuits lors des phases de fabrication précédant la fixation définitive des composants, fixation qui est réalisée selon le cas par la polymérisation de la colle ou par la solidification de la soudure.

On a proposé plusieurs solutions à ce problème, par exemple l'utilisation de la viscosité de la colle avant polymérisation, ou de celle d'un flux décapant pour soudure, ou d'une pâte à souder visqueuse, permet de maintenir provisoirement un composant relativement léger, comme cela est indiqué dans les documents GB-A-1 375 997 ou US-A-4 465 206. Toutefois ce procédé n'est pas pleinement satisfaisant car il impose des contraintes diverses, concernant notamment la viscosité du produit utilisé, et le rapport entre le poids du composant et la surface de ses contacts, et il ne permet pas toutes les manipulations du circuit : en particulier ce dernier doit toujours rester "la tête en haut", c'est-à-dire que les composants non définitivement fixés doivent toujours rester sur la face supérieure. On a aussi proposé d'utiliser une goutte de colle que l'on polymérise immédiatement (au moyen de lumière ultra-violette) et qui maintient le composant pendant une opération ultérieure de soudage à la vague, comme indiqué dans le document US-A-4 312 692.

Cette technique impose toutefois des étapes de fabrication supplémentaires pour mettre en place la colle et pour la polymériser. En outre, cette technique est difficile à utiliser lorsque les composants CMS sont très petits, car la colle (isolante) risque de s'étaler en excès et de déborder sur les plages de connexion électrique.

L'invention se propose de fournir une solution peu coûteuse et efficace à ce problème. Le circuit selon l'invention est à cet effet notamment remarquable en ce que des parties de ladite feuille sont découpées sensiblement selon le périmètre du corps du composant, à l'exception de languettes qui demeurent à l'intérieur de ce périmètre et sont tournées vers le centre de la découpe, et en ce que ces languettes sont repliées, selon une ligne de pliage qui longe le périmètre du corps du composant, et s'appuient sur des parois latérales de ce dernier.

Lorsque le composant CMS est pourvu de plages de connexion à coller ou à souder, disposées le long de ses parois latérales, comme c'est le cas par exemple pour des condensateurs ou des résistances de forme parallélépipédique avec des métallisations sur chacune de leurs deux plus petites faces, des languettes prévues au niveau desdites plages de connexion sont avantageusement recouvertes, au moins partiellement, d'une couche électriquement conductrice imprimée du côté qui est en contact avec le composant, et de la colle conductrice ou de la soudure est appliquée à la jonction entre les plages de connexion et les languettes.

Ainsi le composant est non seulement maintenu, mais aussi connecté électriquement au moyen desdites languettes.

Lorsque le composant est muni de pattes de connexion métalliques attachées à ses parois latérales, comme c'est le car par exemple de transistors et diodes miniatures dans un boîtier, lesdites languettes sont avantageusement disposées entre de pattes des connexion.

Lorsque le composant comporte un corps parallélépipédique muni de pattes de connexion métalliques attachées à deux parois latérales opposées, comme c'est le cas par exemple pour des circuits intégrés miniatures, lesdites languettes sont avantageusement disposées au niveau des deux autres parois latérales, qui ne portent pas de connexion. Dans ce cas des découpes supplémentaires peuvent en outre être prévues entre les pattes, à l'extérieur du périmètre du corps. Ceci a l'avantage d'éviter la possibilité qu'un court-circuit se produise, parceque ces découpes empêchent la colle conductrice ou la soudure de couler d'une patte vers une autre sur la feuille support. En outre, un autre avantage est que ces découpes laissent entre elles des lames qui peuvent se relever et épouser chacune la forme de la patte de connexion qui lui correspond.

Un procédé pour réaliser le circuit selon l'invention est notamment remarquable en ce que, après avoir imprimé les pistes conductrices, on effectue la découpe par poinçonnage, puis on dépose localement de la colle conductrice, à la suite de quoi, la feuille étant appliquée contre une matrice, on introduit à force le composant à sa place dans la découpe de la feuille si bien que c'est le composant lui-même qui provoque le pliage des languettes. Dans une variante où, à la place de la colle, on utilise de la soudure, cette dernière est appliquée avantageusement en faisant passer le circuit sur une vague de soudure à la fin du processus.

Une des applications les plus intéressantes du circuit selon l'invention est son utilisation dans un clavier à touches du type constitué par deux circuits imprimés placés l'un en face de l'autre à faible distance et portant chacun des pastilles de contact électrique en vis à vis de celles de l'autre. Des contacts sont obtenus en poussant l'un des deux circuits imprimés vers l'autre au moyen des touches. Un tel clavier est décrit dans un grand nombre de documents, parmi lesquels on peut citer notamment US-A-3 982 081 ou US-A-4 066 851.

Il est parfois nécessaire d'ajouter au clavier un certain nombre de composants tels que des diodes ou des résistances. En outre on peut souhaiter incorporer au clavier lui-même une partie de l'intelligence artificielle qui exploite les données que l'utilisateur introduit au moyen des touches. Il se pose alors un problème car les composants CMS, reportés de façon connue, sont appliqués sur la face du circuit imprimé qui est munie de métallisations. Or dans un tel clavier les deux faces métallisées sont à l'intérieur du sandwich constitué par les susdits deux circuits imprimés, et les feuilles sont trop rapprochées pour pouvoir accueillir un composant entre elles ! on peut alors utiliser un circuit à double face et à traversées conductrices pour pouvoir reporter les composants sur la face externe opposée à celle qui porte les pastilles de contact des touches. Une telle feuille est beaucoup plus coûteuse qu'une feuille à simple face, par exemple métallisée au moyen de pâte à l'argent ou au graphite. Une autre solution consiste, le composant CMS étant placé sur une des feuilles du côté des susdites pastilles, à prévoir des orifices dans l'autre feuille pour laisser dépasser le corps du composant à l'extérieur du sandwich. Il faut aussi prévoir des orifices dans une feuille intercalaire placée entre les deux circuits imprimés. Comme la place est limitée ces trous doivent être aussi petits que possible et de ce fait la mise en coïncidence des trous d'une feuille à l'autre exige l'usage de moyens de précision trop coûteux.

Le circuit selon l'invention apporte une solution simple et économique lorsqu'on l'utilise pour constituer au moins l'un des deux circuits imprimés qui constituent le clavier car, le coprs du composant étant enfoncé dans les découpes de la feuille et tenu par les languettes, il est déporté vers la face opposée à celle qui porte les pastilles de contact du clavier et la faible distance entre les feuilles n'est plus un problème.

La description qui va suivre, en regard des dessins annexés décrivant des exemples non limitatifs fera bien comprendre comment l'invention peut être réalisée.

Les figures 1A et 1B montrent en plan une découpe selon l'invention, pour un composant CMS du type condensateur ou résistance.

La figure 1C est une vue de profil d'une circuit muni d'une découpe selon la figure 1B, avec le composant en place.

Les figures 2A et 2C correspondent respectivement aux figures 1A et 1C, dont elles représentent une variante.

Les figures 3A et 3B montrent en plan une découpe selon l'invention, pour un composant CMS à pattes de connexion.

La figure 3C est une vue de profil d'un circuit muni d'une découpe selon la figure 3B.

Les figures 4A et 4B montrent en plan une découpe selon l'invention, pour un autre composant CMS à pattes de connexion.

La figure 4C est une vue de profil d'un circuit muni d'une découpe selon la figure 4B, avec le composant en place.

La figure 5 illustre la phase d'introduction du composant selon le procédé de l'invention.

La figure 6 est une coupe dans un clavier comportant un circuit selon l'invention.

La forme d'une découpe dans un circuit imprimé selon l'invention est montrée sur la figure 1A, la feuille à découper étant représentée par la feuille de papier portant la figure.

Un composant est indiqué en 1 par son périmètre tracé en pointillé. Il s'agit ici d'une résistance ou d'un condensateur.

Une découpe en forme de H comprend un trou 3 et quatre fentes 4. Les fentes ont été représentées avec une largeur non nulle pour la clarté du dessin, mais elles peuvent être réduites à une simple coupe sans épaisseur.

Considéré dans le sens de la longueur du composant (ici verticalement) le trou 3 est plus court que le composant et les fentes 4 au contraire dépassent légèrement la longueur du composant. La largeur du trou 3 qui correspond à l'écartement horizontal entre deux fentes 4 est légèrement supérieuure à la largeur du composant.

Par la présence des fentes 4 sont constituées deux languettes 2 qui peuvent être relevées perpendiculairement au plan de la feuille autour d'axes de courbure 6.

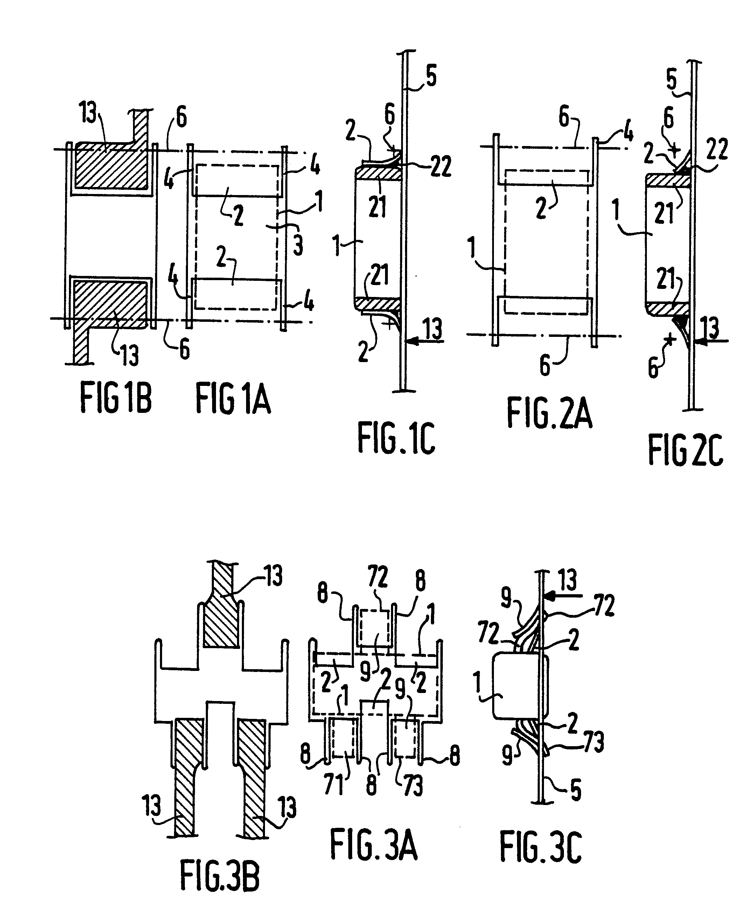

La figure 1B représente la même découpe, et on y a indiqué la forme d'une métallisation conductrice 13 permettant de connecter éléctriquement le composant 1. Pour obtenir le dessin complet il faut superposer les deux figures 1A et 1B que l'on a dessinées côté à côté pour une meilleure clarté.

La figure 1C montre comment les languettes 2 relevées s'appuient sur les parois latérales du composant 1. Elles sont pliées selon une courbure qui possède approximativement un centre de courbure indiqué par 6. De la colle conductrice ou de la soudure 22 est appliquée à la jonction entre les plages de connexion 21 du composant et les languettes 2. La face de la feuille qui porte les métallisations est indiquée par la flèche 13.

La figure 2A montre une variante dans laquelle les languettes 2 sont plus éloignées l'une de l'autre et les fentes 4 s'étendent plus loin à l'extérieur du périmètre du composant.

De ce fait, comme le montre la figure 2C, le centre de courbure 6 est plus éloigné de la paroi du composant 1 et aussi plus éloigné de la feuille 5. Cette variante peut être utilisée avec des feuilles plus rigides que dans le cas de la figure 1.

La variante des figures 2 ne peut toutefois être utilisée que si les tolérances dimensionnelles du composant sont assez étroites.

Une autre forme de découpe est indiquée sur la figure 3A. Elle concerne un composant en boîtier à 3 pattes de connexion.

Le périmètre du corps (c'est-à-dire du boîtier) est indiqué par un pointillé 1. Des pattes 71 à 73 indiquées en pointillés sont attachées aux parois latérales du corps 1.

Lorsqu'on suit le périmètre du corps du composant, par exemple à partir de la patte 71, on rencontre une languette 2 puis la patte 72, une autre languette 2, la patte 73 et enfin une dernière languette 2. Les languettes sont donc disposées entre les pattes de connexion.

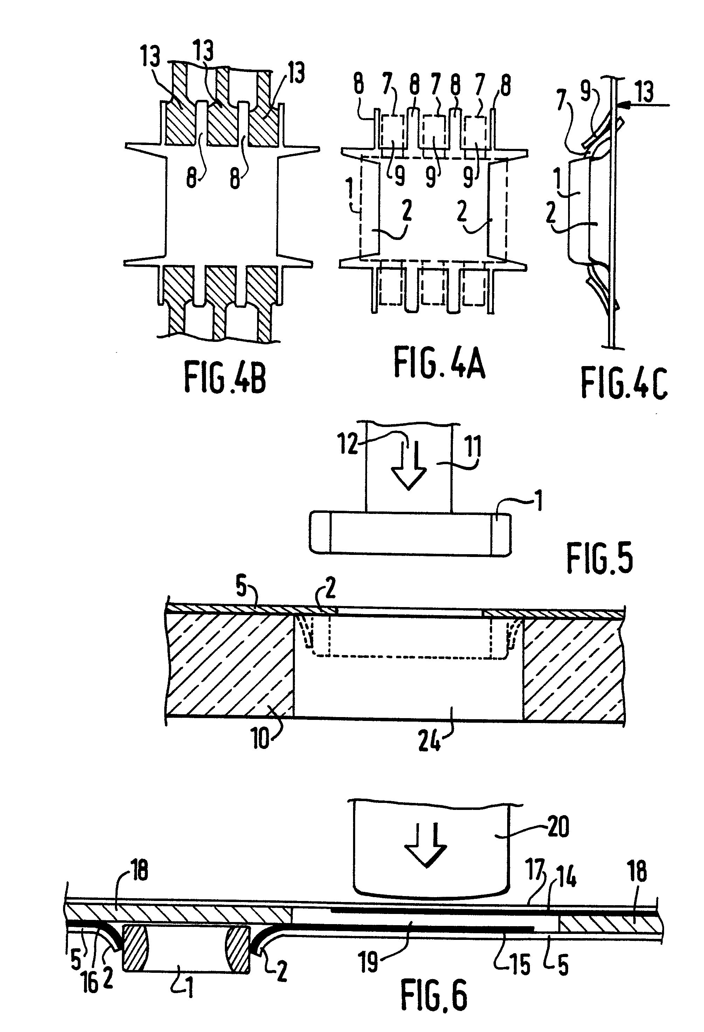

Dans une variante non représentée les deux languettes situées de part et d'autre de la patte 72 pourraient aussi bien être placées le long de chacun des deux petits côtés du périmètre rectangulaire 1, de la même manière que dans le circuit des figures 4 expliquées plus loin.

Des fentes supplémentaires 8 sont prévues de part et d'autres des pattes 72 à 73, à l'extérieur du périmètre 1 du corps.

La figure 3C montre que ces fentes ont pour but de permettre aux parties 9 de la feuille, situées au-dessus des pattes, de se relever et d'épouser la forme des pattes de connexion 72, 73.

Quant aux languettes 2, elles ont pour fonction, comme sur la figure 2C, de maintenir le corps du composant.

Des métallisations 13 dont la forme est indiquée en 13 sur la figure 3B assurent la connexion électrique avec les pattes 9, au moyen, par exemple, d'une colle conductrice déposée sur les métallisations avant la mise en place du composant.

Les figures 4A à 4C correspondent aux figures 3A à 3C, mais elles concernant maintenant un autre composant à pattes de connexion.

Le périmètre du corps du composant est indiqué par un pointillé 1. Des pattes 7 indiquées en pointillés sont attachées aux parties latérales du corps. Ici les languettes sont disposées au niveau des deux parois latérales qui ne portent pas de connexion. Des découpes supplémentaires 8 sont prévues de part et d'autres des pattes, à l'extérieur du périmètre du corps.

Comme dans le cas des figures 3, les figures 4B et 4C montrent les métallisations de connexion 13, et comment les parties 9 situées au-dessus des pattes 7 se relèvent pour épouser leur forme.

Pour réaliser un circuit selon l'invention on commence par imprimer les pistes 13. Le support est par exemple un matériau polyester de 125 micromètres d'épaisseur, et les pistes peuvent être réalisées par sérigraphie avec une encre polymère chargée à l'argent. Pour le dépôt des plages 13, une grande précision n'est pas nécessaire. En effet, ces plages peuvent être confinées à l'intérieur des languettes 2 comme sur la figure 1B, mais elles peuvent aussi dépasser à l'extérieur puisque les découpes 4 (cas des figures 1) ou 8 (cas des figures 3 et 4) assurent leur définition finale.

Dans le cas de la figure 4B les groupes de troismétallisations 13 peuvent même, au niveau des pattes 7 être au départ constitués d'une seule bande horizontale (sur la figure) qui sera divisée ensuite en trois par les découpes 8.

Après le dépôt des pistes on procède au poinçonnage des découpes. Les fentes 4 aussi bien que les fentes 8 peuvent être réalisées au moyen d'un seul poinçon pour 2 fentes consécutives, chacune des 2 parois latérales dudit poinçon correspondant à une fente et constituant avec une matrice qui maintient la feuille une sorte de paire de ciseaux.

Après le poinçonnage on dépose par sérigraphie une couche de colle conductrice sur la métallisation. Il faut noter ici que certaines fentes 8 de la figure 4A, placées entre des pattes 7 contiguës, ont intérêt à être larges, pour éviter un court-circuit de colle conductrice entre deux pattes.

L'opération suivante est illustrée par la figure 5 où une matrice 10 soutient la feuille 5 et est muni d'un orifice 24 situé sous l'emplacement du composant. Le composant 1 est amené par une pipette à aspiration 11 qui descend selon la flèche 12. Lorsque le composant arrive à la position indiquée en pointillé, la pipette le lâche et remonte. Si la colle n'est pas d'un type qui polymérise à température ambiante, il reste à chauffer le circuit en étuve pour assurer la polymérisation.

Dans une variante de ce procédé on utilise des pistes conductrices en cuivre réalisées selon un procédé connu de circuit imprimé, on ne dépose pas de colle avant le poinçonnage, et après la mise en place du composant (figure 5) on fait passer le circuit sur une vague de soudure, la face portant la métallisation étant bien entendu située sous la feuille. On peut aussi bien utiliser une pâte à souder avec une refusion sur plaque chauffante ou en phase vapeur.

La figure 6 représente des parties, en rapport avec l'invention, d'un clavier à touches. Ce dernier est constitué par deux feuilles de circuit imprimé, 5 et 17, placées l'une en face de l'autre à faible distance et portant chacune une métallisation, respectivement 15 et 14. Une feuille intercalaire 18 assure la mise à distance correcte des deux feuilles 5 et 17 et comporte un orifice 19 qui permet aux deux feuilles d'être rapprochées à cet endroit ou les métallisations constituent des pastilles de contact en vis à vis. Cet effet est ob tenu grâce à une pièce mécanique 20 liée à une touche et qui peut descendre et appuyer sur le circuit souple 17, pour mettre en contact l'un avec l'autre les deux pastilles en regard.

L'un des deux circuits est un circuit selon l'invention dont la feuille 5 comporte un orifice avec des languettes 2 qui sont pliées du côté opposé à la feuille intercalaire 18 et maintiennent un composant 1. Ainsi le circuit réalise la connexion en série du composant 1, par exemple une résistance ou une diode, et du contact de touche 15, 14.

Ici la feuille 14 peut assurer l'étanchéité en liaison avec un boîtier inférieur non représenté, pour la protection climatique du composant 1. Il est nécessaire dans ce cas de supporter le circuit par une matrice comportant des évidements apropriés au niveau des composants.

On peut aussi utiliser comme circuit imprimé inférieur un circuit rigide qui ne requiert pas de matrice support,la feuille souple 5 étant alors placée au dessus, à la place de la feuille 14 de la figure 6.

Alors les composants sont situés entre les poussoirs de touche 20 et il peut être nécessaire d'insérer entre les poussoirs et le circuit une feuille d'étanchéité souple.

**Revendications**

1. Circuit électrique comportant des pistes conductrices imprimées sur une feuille isolante souple, muni d'au moins un composant par montage en surface dit "CMS", caractérisé en ce que des parties de ladite feuille sont découpées sensiblement selon le périmètre du corps du composant, à l'exception de languettes qui demeurent à l'intérieur de ce périmètre et sont tournées vers le centre de la découpe, et en ce que ces languettes sont repliées selon une ligne de pliage qui longe le périmètre du corps du composant, et s'appuient sur des parois latérales de ce dernier.

2. Circuit selon la revendication 1, dont le composant est pourvu de plages de connexion, à coller ou à souder, disposées le long de ses parois latérales, caractérisé en ce que des languettes prévues au niveau desdites plages sont au moins partiellement recouvertes d'une couche électriquement conductrice imprimée et en ce que de la colle conductrice ou de la soudure est appliquée à la jonction entre les plages de connexion et ces languettes.

3. Circuit selon la revendication 1, dont le composant est muni de pattes de connexion métalliques attachées à ses parois latérales, caractérisé en ce que lesdites languettes sont disposées entre des pattes de connexion.

4. Circuit selon la revendication 1, dont le composant comporte un corps sensiblement parallélépipédique muni de pattes de connexion métalliques attachées à deux parois latérales opposées, caractérisé en ce que lesdites languettes sont disposées au niveau des deux autres parois latérales, qui ne portent pas de connexion.

5. Circuit selon l'une des revendications 3 ou 4, caractérisé en ce que des fentes supplémentaires sont prévues de part et d'autre des pattes, à l'extérieur du périmètre du corps.

6. Procédé pour réaliser un circuit selon la revendication 1, caractérisé en ce que, après avoir imprimé les pistes conductrices, on effectue la découpe par poinçonnage, puis on dépose localement de la colle conductrice à la suite de quoi, la feuille étant appliquée contre une matrice, on introduit à force le composant à sa place dans la découpe de la feuille, si bien que c'est le composant lui-même qui provoque le pliage des languettes.

7. Procédé pour réalisé un circuit selon la revendication 1, caractérisé en ce que, après avoir imprimé les pistes conductrices, on effectue la découpe par poinçonnage, à la suite de quoi, la feuille étant appliquée contre une matrice on introduit à force le composant à sa place dans la découpe de la feuille, si bien que c'est le composant lui-même qui provoque le pliage des languettes, et enfin on fait passer le circuit sur une vague de soudure.

8. Circuit selon la revendication 1, caractérisé en ce qu'il est utilisé dans un clavier à touches comportant deux circuits imprimés placés l'un en face de l'autre à faible distance et portant chacun des pastilles de contact électrique en vis à vis de celles de l'autre, et en ce qu'il constitue l'un des deux susdits circuits imprimés.

FIG 1B    FIG 1A

FIG.1C

FIG.2A

FIG 2C

FIG.3B

FIG.3A

FIG.3C

FIG.4B

FIG.4A

FIG.4C

FIG.5

FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-2 093 612  (FABRIQUE D'HORLOGERIE DE FONTAINEMELON S.A.)<br>* Page 1, lignes 29-105; figures 1,2 * | 1,6,7 | H 05 K   1/18<br>H 05 K   3/22 |
| A | GB-A-2 037 506  (DAVID NEWTON GRUFFERTY)<br>* Page 1, line 41 - page 2, line 20; figures * | 1,6,7 | |
| A | US-A-2 869 041  (ADMIRAL CORP.) | | |
| A | DE-A-3 501 710  (ALLIED CORP.) | | |

DOMAINES TECHNIQUES RECHERCHES (Int. Cl.4)

H 05 K

Le présent rapport de recherche a été établi pour toutes les revendications

| Lieu de la recherche | Date d'achèvement de la recherche | Examinateur |
|---|---|---|
| LA HAYE | 13-11-1987 | SCHUERMANS N.F.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

OEB Form 1503 03 82